Europäisches Patentamt

European Patent Office

Office européen des brevets

(11) Publication number: **0 140 619 B1**

# EUROPEAN PATENT SPECIFICATION

(45) Date of publication of patent specification: **17.03.93**

(51) Int. Cl.5: **H01R  4/04**, H01B 1/22,
C09J 7/00

(21) Application number: **84306963.4**

(22) Date of filing: **11.10.84**

(54) **Anisotropic-electroconductive adhesive film and circuit connecting method using the same.**

(30) Priority: **14.10.83 JP 193237/83**
**28.11.83 JP 223954/83**
**15.12.83 JP 236883/83**

(43) Date of publication of application:
**08.05.85 Bulletin  85/19**

(45) Publication of the grant of the patent:
**17.03.93 Bulletin  93/11**

(84) Designated Contracting States:
**DE GB**

(56) References cited:
FR-A- 2 275 040
GB-A- 2 047 476
US-A- 3 896 544
US-A- 4 098 945

DERWENT JAPANESE PATENTS GAZETTE,
Week X 43, Issued 1st December 1976, page
9, Derwent Publications Ltd., London, GB; &
JP - A - 51 101 040 (SUWA SEIKOSHA K.K.)
07-09-1976

(73) Proprietor: **Hitachi Chemical Co., Ltd.**
**1-1, Nishishinjuku 2-chome**
**Shinjuku-ku, Tokyo 160(JP)**

(72) Inventor: **Tsukagoshi, Isao**
**1015-8, Oaza Nunogawa**
**Shimodate-shi(JP)**
Inventor: **Yamaguchi, Yutaka**
**7941-169, Yuuki**
**Yuuki-shi(JP)**
Inventor: **Hazama, Keiji**
**568, Hitotonoya**
**Oyama-shi(JP)**
Inventor: **Nakayama, Tadamitsu**
**11-33, Baba-6-chome**
**Tsurumi-ku Yokohama(JP)**

(74) Representative: **Goldin, Douglas Michael et al**
**J.A. KEMP & CO. 14, South Square Gray's Inn**
**London WC1R 5EU (GB)**

EP 0 140 619 B1

**Description**

The present invention relates to an anisotropic-electroconductive adhesive film which is electrically conductive only in the direction perpendicular to the surface thereof and not in any direction parallel to the surface. The invention also relates to a circuit connecting method employing such a film.

Solders and electroconductive adhesives have so far been used widely as means of connecting large scale integrated circuits (LSI) or electrodes of liquid crystal display elements (LCD) to printed circuit boards and of bonding flexible flat cables (FFC) to external connecting terminals of various devices.

However, with the miniaturization of electronic parts and the size reduction of connecting circuits, it has become extremely difficult to connect circuits to one another without causing short circuits between neighboring parts of the circuits in particular when connecting terminals or the like are aligned at fine pitches.

In addition, soldering has a drawback of low reliability in adhesion due to the hard and brittle properties of solder and the liability of bonded parts to be readily separated by a shock or the like.

Electroconductive adhesives, on the other hand, are expensive because conductive fillers need to be incorporated to high concentrations of at least 20% by volume into adhesives in order to obtain necessary electric conductivity. Further drawbacks of conductive adhesives are that variation in the conductivity is caused by such factors as the precipitation of the filler during storage or difficulty in uniform coating thereof and environmental pollution by the organic solvent contained therein.

An example of the attempts to eliminate these drawbacks is the method disclosed in Japanese Patent Application Kokai (Laid-Open) No. 147,732/78, which comprises applying a conductive adhesive prepared by incorporating 5 to 25% by weight of electroconductive carbon black as an electroconductive filler into a heat-sensitive adhesive and conducting an electric current through the layer of the applied adhesive to generate Joule's heat, thereby completing bonding.

According to this method, however, the upper limit of the electroconductivity is $10°\,\Omega\text{-cm}^{-1}$, the appearance is black in color, and the transparency is lost completely, since carbon is used as the electroconductive filler. Moreover, the bonding operation requires a long time ranging from 10 minutes to 10 hours and the workability is inferior, since the adhesion is achieved with Joule's heat.

Adhesive tapes having the features according to the preamble of claim 1 are also known from JP-A-101040/76. Such adhesive tapes, however, are inferior in adhesive properties and transparency, since conductive fillers such as metal particles need to be incorporated in large quantities of at least 10% by volume in order to secure the necessary electroconductivity.

Further, for circuit connecting purposes, there are used in practice connecting materials having anisotropic-electroconductivity which materials are produced by linear alignment of metal wires, carbon filaments, or carbon particles in polymers, for example, silicone rubber. However, these connecting materials have a number of drawbacks in that the minimum separation width of the conductors or insulators is at least 0.2 mm at best, thus the use of these materials for connecting fine circuits is limited, compression pressure should always be applied in order to maintain the connection in a good state and this requires a special fixing means, which results in restricting equipment designs, and the materials themselves are opaque so that the adjustment of relative positions of circuits is complicated when the circuits are superposed and connected together.

Thus, an object of the present invention is to provide an anisotropic-electroconductive adhesive film which permits simple electroconductive connection to be formed between two groups of connecting terminals which face each other and which allows easy alignment at fine pitches. Another object of the invention is to provide a method for connecting circuits by using said film.

According to the invention, there is provided an anisotropic-electroconductive adhesive film and a process for connecting circuits as set out in the claims 1 and 8.

In the attached drawings, Fig. 1 is a cross-sectional view of the anisotropic-electroconductive adhesive film according to the invention, Fig. 2 is a perspective view showing the connected state of a group of connecting terminals formed on a circuit board and Fig. 3 is a schematic cross-sectional view showing the concept of the connecting operations.

This invention is explained in detail referring to the drawings.

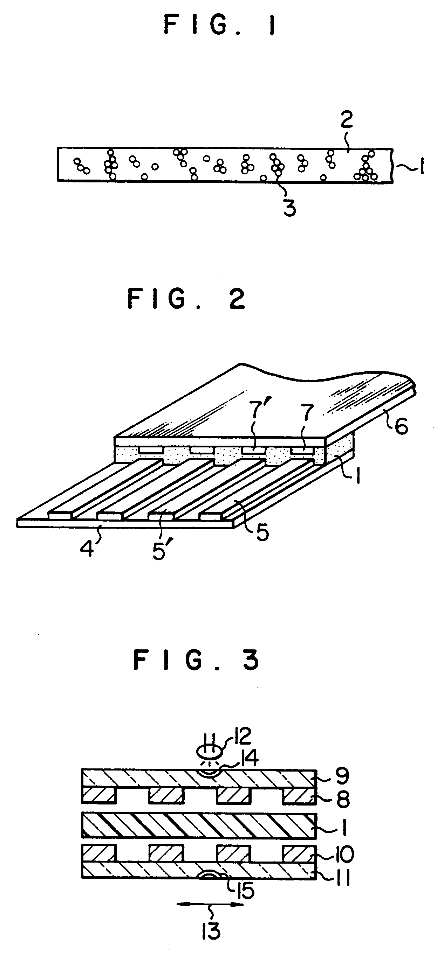

Fig. 1 shows the fundamental construction of the anisotropic-electroconductive adhesive film according to the invention. As shown in Fig. 1, the adhesive film comprises an adhesive layer 2 of bonding material and electroconductive particles 3 dispersed therein. The adhesive layer 2 is an electrical insulator and has functions of holding electroconductive particles 3 with dispersed state and adhering a printed circuit board or the like. The layer 2 undergoes plastic deformation on applying pressure with heating, and this brings electroconductive particles into contact one with another along the direction of the pressure application so as to maintain electric conductivity permanently.

Fig. 2 shows the state wherein a connecting terminal 5 of a flexible printed circuit board 4 is connected electrically with a connecting terminal 7 of a flexible flat cable 6 by using such an adhesive film as shown in Fig. 1. In this case, the opposing pairs of connecting terminals 5-7, 5'-7', ... are each in an electrically conductive state while the communications between the neighboring terminals 5 and 5', ... and between the neighboring terminals 7 and 7', ... are each in an electrically insulated state.

The adhesive film according to the invention has an anisotropy in electrical conductivity between the directions perpendicular and parallel to the surface thereof (hereinafter for convenience, the direction perpendicular to the film surface is referred to as the "thickness direction" and the directions parallel to the film surface as the "plane direction". The film has a resistivity of at least $10^6$ $\Omega$-cm in the plane direction and a resistivity of not more than $10^3$ $\Omega$-cm in the thickness direction, exhibiting thus a great anisotropy in resistivity. The adhesive film has a small minimum separation width of resistance both in the plane and the thickness direction, thus having good resolution. That is, the minimum insulation width in the film plane direction is 0.05 mm. Moreover the application of the film can be accomplished under heat-sensitive and pressure-sensitive conditions. Accordingly, the adhesive film offers good application workability and strong adhesion as well as high electrical conductivity and additionally has a considerably high transparency.

The above-mentioned features of the film are due to the high anisotropic electrical conductivity that has become obtainable by the incorporation of special electroconductive particles in small amounts and due to the arbitrary compounding enabled thereby for the film formation. Conceivably the shape of the electroconductive particles is the main cause of the fact that the film exhibits a high anisotropic conductivity with small amounts of electroconductive particles. In other words, the adhesive film in application becomes fluid with heat and pressure and each electroconductive particle embedded in the surface layer of the film will be in one-point contact with the surface of the conductor to be bonded, so that the adhesive film sufficiently adapts itself to the adhesion surface of the conductor and provides high bond strength. Electroconductive particles in the surface layer take such configurations as to readily contact with electroconductive particles present on the deeper side, forming links in the thickness direction and as to have a little opportunity to contact with other electroconductive particles in the plane direction, whereby the anisotropic conductivity is obtained.

The following description refers to materials used in the invention.

The electroconductive particles used in the invention are metallic particles of 1 to 50 $\mu$m in diameter. The ratio of the smallest diameter to the largest diameter of each particle is 0.5 to 1.0. The particles are contained in the adhesive component in an amount of 0.1 to 10% by volume. The maximum particle size is desirably 1 to 50 $\mu$m, more preferably 1 to 10 $\mu$m. When it is less than 1 $\mu$m, a larger amount of electroconductive particles are required, which results in deteriorating the bond strength greatly. When the maximum particle size is more than 50 $\mu$m, it is impossible to obtain a smooth adhesive surface having good affinity to an adherend from the viewpoint of thickness of the adhesive film, which results in failing to give sufficient adhesiveness. Further, insulating properties and resolution properties at electric conduction are also undesirably worsened.

As regards the shape of the electroconductive particles, the ratio of the smallest diameter to the largest of each particle (hereinafter referred to as "the aspect ratio") is about 0.5 to 1.0 as stated above. If the aspect ratio is out of the above range, the balance between the electroconductivity and the adhesiveness will be disturbed. A typical example of the particle shapes satisfying the above condition is spherical or nearly spherical. However, the shape is not particularly limited so long as the aspect ratio falls in the above range. The particles are allowed to have projections or depressions on the surface.

The particle size herein means the average diameter of all the particles.

The shape and diameter of the particles are conveniently measured by way of, for example, an electron microscope.

When the electroconductive particles are, for example, spherical, the adhesive film is fluidized by heat and pressure at the time of adhesion, which results in making it possible to contact one point of the special particles with the conductor surface.

In contrast to this, flaky conductive particles, for example, are aligned with longer axes thereof being directed parallel to the adhesive surface in the steady state and the adherend surface is therefore occupied mostly with the electroconductive particles, thereby the adhesive properties are lowered to a large extent.

The electroconductive particles can be produced by any possible method from the following materials: Metals, for example, Ni, Fe, Cr, Co, Al, Sb, Mo, Cu, Ag, Pt, and Au, and alloys and oxides of these metals. The above materials may be used alone or in combination.

It is also possible to use metal-coated particles of non-conductive materials, for example, glass and plastics.

Suitable content of conductive particles in the adhesive component film is 0.1 to 10% by volume. The thickness of the adhesive film is at least 110% of the average particle size of the electroconductive particles contained and desirably not more than 100 μm. With the particle content less than 0.1% by volume, no satisfactory electrical conductivity is obtained, and when the content exceeds 10% by volume, the bond strength much lowers and no sufficient transparency of the film is obtainable.

The following description refers to compounding for the adhesive film.

For selecting the polymer used for the adhesive, some considerations are necessary depending upon the method of applying the adhesive film, in other words, depending upon whether the film is of heat sensitive type or of pressure sensitive type. The heat sensitive type of adhesive film is applied by heating to soften and flow on the adherend surface, thereby bonding the object. For the film of heat sensitive type, a polymer relatively hard at ordinary temperatures is used. On the other hand, the pressure sensitive type of adhesive film, which is applied with pressure on an adherend, is relatively soft to such an extent that stickiness thereof is perceptible even at ordinary temperatures.

As the heat sensitive type of adhesive film, various polymers can be adapted while thermoplastic polymers that exhibit plasticity on heating are usually employed as a main component. These polymers include, for example, an ethylene-vinyl acetate copolymer, polyethylene, ethylene-propylene copolymer, ethylene-acrylate copolymer, acrylic rubber, polyisobutylene, atactic polypropylene, poly(vinyl butyral), styrene-butadiene copolymer, polybutadiene, ethyl-cellulose, polyamide, and polyurethane. These polymers may be used alone or as a mixture thereof.

As the pressure sensitive type of adhesive film, polymers exhibiting stickiness even at ordinary temperatures can be employed. These polymers include an acrylic rubber, natural rubber, silicone rubber, polychloroprene, butadiene-styrene copolymer, ethylene-vinyl acetate copolymer, polyisobutylene, and poly(vinyl ether) rubber. These polymers also may be used alone or as a mixture thereof.

In addition to these polymers, tackifiers and conventional additives such as plasticizers, crosslinking agents, and antioxidants can be used, if necessary, for either the heat sensitive type or the pressure sensitive type. Suitable tackifiers for use herein include, for example, rosin family resins such as rosin, hydro-rosin, ester gum, and maleic acid-modified rosin, petroleum resin, xylene resin, and cumarone-indene resin. These tackifiers may be used alone or as a mixture thereof.

For compounding materials for the adhesive film, a mixture of the polymer and additives, which are used as required, is either dissolved in a solvent or fused to liquid form, and mixed with electroconductive particles by a conventional method such as stirring. Thus, an electroconductive adhesive composition is obtained.

In this case, a surfactant, for example, can be used, if required, as a dispersing agent for the electroconductive particles.

The above electroconductive adhesive composition can be coated on paper, plastic film, or the like, which is coated with a separator if necessary for helping the later separation of the adhesive film, by means of a roll coater or the like, followed by drying, or by hot melt coating to give an electroconductive adhesive film. In the case of the heat sensitive type that does not exhibit stickiness at room temperature, the adhesive film alone without using such a separator can be wound up into a roll or folded up.

The thickness of the adhesive film is decided by considering the relation to the diameter of the electroconductive particles used and characteristics of the film.

That is, the thickness needs to be at least 110% of the particle size of the electroconductive particles in order to hold the particles satisfactorily in the adhesive. If the thickness is less than 110%, some of the electroconductive particles will be protected not completely with the adhesive, and in consequence will be oxidized or corroded, thereby the electrical conductivity being deteriorated. Also from the viewpoint of characteristics of the adhesive film, the thickness is required in the range of preferably 5 to 100 μm, particularly preferably 5 to 50 μm. When the thickness is less than 5 μm, no sufficient adhesiveness is obtained, and the thickness more than 100 μm is impractical since a large amount of electroconductive particles need to be mixed in order to secure sufficient electrical conductivity with such a thick film.

One or both sides of the formed adhesive film may be covered with separator films if necessary for the purpose of protecting from the adherence of dust or the like. The adhesive film, when both sides thereof are covered with separator films, can be continuously wound up into a roll or folded up.

The thus obtained adhesive film has good transparency. Transparent adhesive films are advantageous in that quality control in the production process is easy to practice in the assembly of display devices or the like, such structures thereof can be designed that the objects to bond can be seen through in bonding operations, and the adjustment of relative positions (hereinafter this adjustment is referred to as registration) for bonding circuits is facilitated and thereby the film application can be automated.

4

For connecting a pair of circuits by using the adhesive film, the following facilities and techniques can be used. In the case of the heat sensitive type of adhesive film, the film is preliminarily attached onto all the surfaces of connecting terminals on an adherent A, a separator, if present on the film, is peeled off, the connecting terminals on the other adherend B are placed on the film face to face, and the bonding is accomplished with a hot press or heat roll.

In the case of the pressure sensitive type, customary bonding techniques such as compression between rolls can be adopted.

The anisotropic-electroconductive film according to the invention has a total light transmittance of at least 40% as measured in accordance with JIS K-6714. This is favorable since optical registration of the portions to be bonded together is possible when at least one of the circuit boards is a flexible printed circuit board that comprises a circuit formed on a transparent film.

The outline of such registration is illustrated below referring to Fig. 3. In Fig. 3, 1 denotes an anisotropic-electroconductive adhesive film according to the invention which is interposed between the upper circuit board 9 having connecting terminals 8 and the lower circuit board 11 having connecting terminals 10. As a light source 12, a usual electric lamp or fluorescent lamp can be used, preferably provided with a condenser, but the particularly preferred light source is a laser from the viewpoint of lineality of light.

While the base materials of the circuit board 9 and 10 are preferably both transparent, at least the circuit board 9 on the light source 12 side is required to be transparent.

Light from the light source 12 enters the upper circuit board 9, where the incident light is modified into a pattern of light according to the opaque connecting terminals 8, and the pattern of light is then passed through the adhesive film 1 and reaches the lower circuit board 11. Then, the lower circuit board 11 is moved in parallel to the upper circuit board 9 so that the connecting terminals 10 will be in agreement with the pattern of light (the shadows of the terminals 8), for example, by a driving means 13 provided with a photosensor. After this registration of the upper and lower groups of connecting terminals, both circuit boards 9 and 11 are pressed with or without heating, thereby completing the bonding.

When both circuit boards are transparent, the registration can also be accomplished by recording marks 14 and 15 for registration on the boards 9 and 11, respectively, and utilizing light from the light source 12.

When the circuit board 11 is opaque, light from the light source 12, after passing through the adhesive film 1, reaches the circuit board 11, is converted into a signal of reflected light according to the level difference and reflectivity difference between the surface of the circuit substrate 11 and the surface of the connecting terminals 10. This reflected light passes through the adhesive film 1 and the circuit board 9 to go out toward the light source 12.

The registration can be accomplished by moving the circuit board 11 by the driving means 13 provided with a photosensor so that the reflected light signal will be in accordance with the connecting terminals 8.

The invention is illustrated in further detail referring to the following examples. In the examples, "parts" and "%" are by weight unless otherwise noted; the compounding proportions for adhesives are expressed in terms of solids; results obtained are all shown in Tables 1 and 2; referring to metal particle sizes, the aspect ratio of the specimen was determined from the respective mean values of the maximum diameters and minimum diameters measured by a scanning electron microscope on 10 or more of the specimen particles; and the particle size was represented by the mean value of said maximum diameters.

Examples 1 and 2

An ethylene-vinyl acetate copolymer (mfd. by Mitsui Polychemicals Co., Ltd. under the tradename of Elvax 560; vinyl acetate content 4%, MI 3.5) and a rosin-base tackifier (mfd. by The Japanese Geon Co., Ltd. under the tradename of Quinton B-170; softening point 70°C) were each dissolved in toluene, respectively, to a concentration of 20%.

Both the solutions (100 parts and 100 parts) were mixed, and in two portions of this mixture were added silver-coated glass beads (supplied by Toshiba-Ballotini Co., Ltd. under the tradename of Silver Beads S-3000S-3; spherical shape, particle size 45 $\mu$m, aspect ratio 0.95) to different concentrations. The mixtures were stirred to prepare adhesive compounded liquids. Each compounded liquid was applied on a separator film (a 25-$\mu$m thick poly(ethylene terephthalate) film surface-treated with a silicone) by means of bar coater so as to give a dry thickness of 50 $\mu$m. The coats were dried at 120°C for 3 minutes to remove toluene to form adhesive films. A metal plate (SUS-430BA, 500 $\mu$m thick) and a copper foil 35 $\mu$m thick were bonded together with each adhesive film thus obtained. That is, each adhesive film was applied on one SUS-430BA sheet, the separator film was peeled off, and one copper foil was bonded onto the stripped surface of the adhesive by using a pair of heat rolls (heated to 120°C). Properties of the films and results of the bonding

5

are shown in Table 1.

From these results, it is proved that adhesive strength and thickness-directional conductivity sufficient for practical use could be obtained by simple bonding operation using the above films. In addition, these films were found to have considerably high transparency, that is, the total light transmittance was 40% or more, since contents of the electroconductive particle were low.

Comparative Example 1

An adhesive film was prepared in the same manner as in Examples 1 and 2 except that the content of the electroconductive particle was increased to 20% by volume.

In this case, the adhesiveness was by far inferior though the conductivity was good. The total light transmittance of the adhesive film was 20% and the low clarity was also ascertained by visual observation.

Examples 3 to 5

Adhesive films were prepared by following the procedure of Examples 1 and 2, but the materials used and the thickness of the coats were varied and the coating was carried out by means of a hot-melt applicator (without using any solvent).

That is, a styrene-butadiene block copolymer (mfd. by Asahi Chemical Industry Co., Ltd. under the tradename of Toughprene A, hereinafter designated as SBR; MI 2.6) and an aromatic tackifier (mfd. by Mitsui Petrochemical Industries Co., Ltd., tradename, Petrosin #150; softening point 150°C) were employed. The compounding ratio of the SBR to the tackifier was 100 parts : 50 parts. The conductive particle used was a nickel powder (supplied by International Nickel Co. under the tradename of Carbonyl 123; spherical shape, average particle size 4.5 $\mu$m, fine projections and depressions were present throughout the surface, aspect ratio 0.70).

The SBR and the tackifier (the above compounding ratio) were fed into a melt mixer attached to the hot-melt applicator and were melted by heating. Said conductive particle was added to the melt, and coating films of different thicknesses were prepared. The evaluation of the thus prepared adhesive films was conducted in the same manner as in Examples 1 and 2 except that the application of films for bonding was carried out with a hot press (temperature of object: 160°C, pressure 2 kg/cm², press time 5 seconds). All the obtained adhesive films showed considerably high transparency.

Results of the evaluation, as shown in Table 1, indicated that all the films had high adhesive strength and exhibited low resistance characteristics.

The resistivities in the plane direction were higher by several orders than those in the thickness direction, showing high anisotropy in electroconductivity.

Comparative Example 2

An adhesive film was prepared in the same manner as in Examples 3 to 5 except that the thickness of the coat was made 150 $\mu$m. The resistivity in the thickness direction was as high as $10^8$ $\Omega$-cm. The adhesive film showed considerably low transparency.

Comparative Example 3

An adhesive film was prepared by following the procedure of Example 4 but using a flaky nickel powder (thickness 0.6 $\mu$m, largest diameter ca. 40 $\mu$m, aspect ratio 0.015).

The film showed a very low adhesive strength and a nearly isotropic electroconductivity.

Example 6

To a toluene solution of an adhesive compound of 100 parts of a natural rubber (grade 1, masticated for 30 minutes) and 30 parts of a polyterpene resin (softening point 100°C), was added 2% by volume of an aluminum powder (supplied by Toyo Aluminum Co., Ltd. under the tradename of AC-2500; oval shape, particle size 30 $\mu$m, aspect ratio 0.5), and the mixture was well stirred.

In the same manner as in Examples 1 and 2, this mixture was applied on a separator film of 100 $\mu$m in total thickness which had been prepared by coating a glassine paper substrate with a polyethylene layer and treating the surface of the polyethylene layer with a silicone. The coated separator was dried, giving an adhesive film 40 $\mu$m thick.

Using this adhesive film, a 500-$\mu$m thick stainless steel sheet (SUS 430BA) and a 35-$\mu$m thick copper foil were bonded together by compressing with a pair of rubber rolls.

In this case, the adhesive film showed high stickiness at room temperature and could be applied with simple operation. The resulting resistivity in the thickness direction was as low as $10^{-2}$ $\Omega$-cm.

The adhesive film was considerably transparent, that is, the total light transmittance was 70%.

Example 7

An adhesive compound composed of 100 parts of an acrylic polymer (mfd. by Toagosei Chemical Industry Co., Ltd. tradename, Aron S-1511) and of 1 part of a crosslinking agent (supplied by Nippon Polyurethane Co., Ltd. under the tradename of Colonate L) was mixed with 5% by volume of a silver powder (supplied by Fukuda Metal Foil Co., Ltd. under the tradename of Silcoat Ag. C-BOB; spherical shape, particle size 1.9 $\mu$m, aspect ratio 0.5). From this mixture, an adhesive film 10 $\mu$m thick was prepared and evaluated in the same manner as in Example 6.

The film showed high stickiness and could be applied simply at room temperature by using a pair of rubber rolls. The resulting resistivity in the thickness direction was as low as $10^{-3}$ $\Omega$-cm, and the transparency was sufficient for practical use.

In addition, the crosslinking agent incorporated into the adhesive gave high cohesion, that is, high heat resistance to the adhesive film.

Table 1

| Example No. | Content of electroconductive particles (vol.%) | Thickness of adhesive film (μm) | Resistivity (Ω-cm) Thickness direction | Resistivity (Ω-cm) Plane direction | Adhesive strength (kg/cm) | Total light transmittance (%) |
|---|---|---|---|---|---|---|
| Ex. 1 | 0.1 | 50 | $1 \times 10^2$ | $3 \times 10^8$ | 2.4 | 70 |
| Ex. 2 | 10 | 50 | $5 \times 10^{-2}$ | $4 \times 10^6$ | 1.8 | 40 |
| Com.Ex.1 | 20 | 50 | $3 \times 10^{-3}$ | $3 \times 10^{-2}$ | 0.1 | 20 |
| Ex. 3 | 2 | 5 | $4 \times 10^{-3}$ | $5 \times 10^8$ | 0.9 | 85 |
| Ex. 4 | 2 | 30 | $2 \times 10^{-1}$ | $7 \times 10^9$ | 2.1 | 70 |
| Ex. 5 | 2 | 100 | $6 \times 10^3$ | $3 \times 10^{10}$ | 2.8 | 50 |
| Com.Ex.2 | 2 | 150 | $7 \times 10^8$ | $4 \times 10^{11}$ | 3.2 | 30 |
| Com.Ex.3 | 2 | 30 | $2 \times 10^3$ | $4 \times 10^3$ | 0.2 | 40 |
| Ex. 6 | 3 | 40 | $1 \times 10^{-2}$ | $5 \times 10^9$ | 0.8 | 70 |
| Ex. 7 | 5 | 10 | $1 \times 10^{-3}$ | $1 \times 10^3$ | 0.4 | 60 |

Test methods for the characteristics shown in Table 1 were as follows:

1) Resistivity in the thickness direction: A stainless steel sheet (SUS-430 BA) and an aluminum foil of 0.5 cm$^2$ in surface area were bonded together through an adhesive film specimen so that the edge effect would be eliminated, the resistance of the adhesive film in the thickness direction was measured, and the found value was converted into volume resistivity.

2) Resistivity in the plane direction: An adhesive film specimen was bonded onto an insulating polyester film of 50 $\mu$m in thickness, the resistance of the film in the plane direction was measured at a specimen width of 0.5 cm with the space between the electrodes being set to 0.5 cm, and the found value was converted into volume resistivity.

For converting the found resistance into volume resistivity in the above 1) and 2), the following equation was used:

$$\rho = \frac{SR}{\ell}$$

wherein

$\rho$ :    volume resistivity ($\Omega$-cm),
S :    cross-sectional area of specimen (cm$^2$),
R :    found value of resistance ($\Omega$), and
$\ell$ :    space between electrodes (cm).

3) Adhesive strength: The 180°-degree peeling method in accordance with JIS Z-0237 was applied. The measurement was conducted at a peeling speed 50 mm/min., 20°C, and 65% RH by using a copper foil bent by 90° degree.

4) Total light transmittance: This was measured in accordance with JIS K-6714 using a digital turbidimeter (Model NDH-20D of Nippon Denshoku Kogyo K.K.).

Examples 8 to 11 and Comparative Examples 4 and 5

The same ethylene-vinyl acetate copolymer and the same rosin-base tackifier (softening point 70°C) as used in Example 1 were dissolved in equal amounts in toluene to prepare solutions of concentration 20%. A nickel powder (particle shape: spherical, average particle size: 4.5 $\mu$m, aspect ratio: 0.70) having fine projections and depressions was mixed in the proportions shown in Table 2 with the above solutions. The mixtures were each ball-milled for 24 hours to give adhesive compounded liquids. Each compounded liquid was applied on a 25-$\mu$m thick polyester film surface-treated with a releasing agent by means of a bar coater so as to give a dry thickness of 30 $\mu$m, and was dried at 120°C for 3 minutes to remove the toluene. In this way, adhesive films of different conductive particle contents were obtained. Using each adhesive film, two flexible polyester circuit boards (pitch of circuit lines: 0.1 mm, line width 0.05 mm) were coupled together by opposing the boards through the adhesive film, registering the circuits, and bonding together each pair of opposing lines by compressing a pair of heat rolls (120°C). Characteristics of the thus coupled circuits are shown in Table 2.

These results revealed that bond strength and thickness-directional conductivity both sufficient for practical use could be obtained with simple bonding operation using the films containing the conductive particles in concentrations of 0.1 to 10.0% by volume.

In addition, these films were found to have considerably high transparency, that is, the total light transmittance was 40% or more, since contents of the conductive particles were low.

Comparative Example 6

An adhesive film was prepared in the same manner as in Example 10 but using a flaky nickel powder (particle shape: flaky, thickness 0.6 $\mu$m, largest diameter ca. 40 $\mu$m, aspect ratio 0.015).

The film showed a very low bond strength and a nearly isotropic electroconductivity.

Example 12

To a toluene solution of an adhesive compound of 100 parts of a natural rubber (grade 1, masticated for 30 minutes) and 30 parts of a polyterpene resin (softening point 100°C), was added 2% by volume of an aluminum powder (particle shape: oval, particle diameter 10 $\mu$m, aspect ratio 0.5), and the mixture was well stirred.

In the same manner as in Example 8, this mixture was applied on a separator film of 100 $\mu$m in total thickness which had been prepared by coating a glassine paper substrate with a polyethylene layer and treating the surface of the polyethylene layer with a silicone. The coated separator was dried, giving an adhesive film 20 $\mu$m thick.

Using this adhesive film, two flexible circuit boards (pitch of circuit lines: 0.2 mm, line width: 0.1 mm) were coupled together in the same manner as in Example 8.

In this case, the adhesive film showed high stickiness at room temperature and could be applied with simple operation. The resulting resistivity in the thickness direction was as low as $10^{-1}$ $\Omega$-cm.

The adhesive film was considerably transparent, that is, the total light transmittance was 70%.

Example 13

An adhesive compound composed of 100 parts of an acrylic polymer and of 1 part of an isocyanate type crosslinking agent was mixed with 10% by volume of a silver powder (particle shape: spherical, particle size 0.5 $\mu$m, aspect ratio 0.9). From this mixture, an adhesive film 10 $\mu$m thick was prepared and evaluated in the same manner as in Example 12.

The film showed high stickiness and could be applied simply at room temperature by using a pair of rubber rolls. The resulting resistivity in the thickness direction was $10^{-3}$ $\Omega$-cm, and the transparency was sufficient for practical use.

In addition, the crosslinking agent incorporated into the adhesive gave high cohesion, that is, high heat resistance to the adhesive film.

Table 2

| Example No. | Electroconductive particles | | | Thickness of adhesive film (μm) | Resistivity (Ω-cm) | | Adhesive strength (Kg/cm) | Total light transmittance (%) |
|---|---|---|---|---|---|---|---|---|
| | Particle size (μm) | Aspect ratio | Amount added (vol%) | | Thickness direction | Plane direction | | |
| Com.Ex.4 | 4.5 | 0.7 | 0.05 | 30 | $3 \times 10^6$ | $5 \times 10^9$ | 1.2 | 85 |
| Ex. 8 | " | " | 0.1 | " | $7 \times 10^2$ | $1 \times 10^8$ | 1.3 | 85 |
| Ex. 9 | " | " | 2.0 | " | $2 \times 10^{-1}$ | $8 \times 10^7$ | 1.0 | 69 |
| Ex. 10 | " | " | 5.0 | " | $5 \times 10^{-2}$ | $4 \times 10^7$ | 0.8 | 63 |
| Ex. 11 | " | " | 10.0 | " | $1 \times 10^{-2}$ | $5 \times 10^6$ | 0.6 | 44 |
| Com.Ex.5 | " | " | 20.0 | " | $2 \times 10^{-3}$ | $5 \times 10^0$ | 0.2 | 30 |
| Com.Ex.6 | 40 | 0.015 | 5.0 | " | $2 \times 10^3$ | $6 \times 10^3$ | 0.1 | 41 |
| Ex. 12 | 10 | 0.5 | 2.0 | 20 | $1 \times 10^{-1}$ | $5 \times 10^7$ | 0.7 | 70 |
| Ex. 13 | 0.5 | 0.9 | 10.0 | 10 | $1 \times 10^{-3}$ | $1 \times 10^7$ | 0.3 | 45 |

As described in detail hereinbefore, the anisotropic-electroconductive adhesive film according to the present invention exhibits sufficient anisotropic electroconductivity due to a specified electroconductive particle mixed and has high bond strength since the content of the particle is as low as 0.1 to 10% by volume.

Since the adhesive film is available in sheet or film form, a stable electrical conductivity can be constantly obtained, bonding operation therewith is simple and can be completed in a short time, thus a

11

EP 0 140 619 B1

considerable reduction in process time being possible. Moreover, there is no hazard of environmental pollution since bonding operation with this film is feasible without using any solvent. Furthermore, this film has good transparency due to the low content of the electroconductive particle. Accordingly, connection of circuits can be carried out by an optical means with this film and therefore accurate registration of circuits is possible. Having anisotropic electroconductivity, this film can be applied to fine circuits, and the bonding function of the film enables the bonding and fixing of circuits simultaneously with the registration. This makes possible automatic connection of circuits, and thus the improvement of the registration accuracy and much labor saving will become possible.

**Claims**

1. An anisotropically electroconductive film for forming electrical connections by application of pressure comprising a layer of adhesive polymer binder having dispersed therein electroconductive particles, the thickness of the binder layer being greater than the particle size of the electroconductive particles characterised in that

(i) the thickness of the binder-layer is at least 110% of the average particle size of the electroconductive particles and is not more than 100 $\mu$m

(ii) the polymer binder layer has dispersed therein from 0.1 to 10% by volume of electroconductive particles having an average particle size of from 1 to 50 $\mu$m, the ratio of the minimum particle diameter to the maximum particle diameter of each particle being from 0.5 to 1.0

(iii) the film is not electrically conductive prior to the application of heat and pressure

(iv) after plastic deformation by application of heat and pressure the film is electrically conductive in the thickness direction but not in any plane direction and the electroconductive particles have a specific resistance of $10^{-5}$ $\Omega$-cm or less and the film has a total light transmittance of 40% or more as measured in accordance with JIS K-6714.

2. A film according to claim 1, wherein the adhesive is a heat-sensitive adhesive containing a thermoplastic polymer as a main component.

3. A film according to claim 2, wherein the thermoplastic polymer is an ethylene-vinyl acetate copolymer, a polyethylene, an ethylene-propylene copolymer, an ethylene-acrylate copolymer, an acrylic rubber, a polyisobutylene, an atactic polypropylene, a poly(vinylbutyral), a styrenebutadiene copolymer, a polybutadiene, ethyl-cellulose, a polyamide, a polyurethane or a mixture thereof.

4. A film according to claim 1, wherein the adhesive is a pressure-sensitive adhesive containing a polymer which is sticky at room temperature.

5. A film according to claim 4, wherein the polymer is an acrylic rubber, natural rubber, a silicone rubber, a polychloroprene, a butadiene-styrene copolymer, an ethylenevinyl acetate copolymer, a polyisobutylene, a poly(vinyl ether) rubber, or a mixture thereof.

6. A film according to any one of the preceding claims, having a resistivity in the plane direction of $10^6$ $\Omega$-cm or more, a minimum insulating width of 0.05 mm, a resistivity in the thickness direction of $10^3$ $\Omega$-cm or less, and adhesive strength of 300 g/cm or more.

7. A film according to any one of the preceding claims, wherein the electroconductive particles are particles of Ni, Fe, Cr, Co, Al, Sb, Mo, Cu, Ag, Pt, Au or a mixture thereof, or glass or plastic particles coated with these metals.

8. A method for connecting circuits comprising interposing a film which is not electrically conductive comprising a layer of polymer binder not more than 100 $\mu$m in thickness having dispersed therein from 0.1 to 10% by volume of electroconductive particles having an average particle size of from 1 to 50 $\mu$m, the ratio of the minimum particle diameter to the maximum particle diameter of each particle being from 0.5 to 1.0, the thickness of the binder-layer being at least 110% of the average particle size of the electroconductive particles and the polymer binder being an adhesive, the electrical connection film having a total light transmittance of at least 40% as measured in accordance with JIS K-6714, between two circuit boards each provided with connecting terminals on the respective surfaces facing each other, at least one of the circuit boards being transparent to light, optically adjusting the two circuits to

12

proper relative positions and connecting together the opposed connecting terminals by application of heat and pressure to cause plastic deformation of the film such that the film becomes electrically conductive in the thickness direction but not in any plane direction.

## Patentansprüche

1. Anisotroper elektrisch leitfähiger Film zur Bildung von elektrischen Verbindungen durch Anwendung von Druck, welcher eine Schicht eines klebenden Polymer-Bindemittels mit darin dispergierten elektrisch leitfähigen Teilchen enthält, wobei die Dicke der Bindemittelschicht größer ist als die Teilchengröße der elektrisch leitfähigen Teilchen, dadurch **gekennzeichnet,** daß
   (i) die Dicke der Bindemittelschicht mindestens 110% der mittleren Teilchengröße der elektrisch leitfähigen Teilchen beträgt und nicht mehr als 100 $\mu$m ist,
   (ii) in der Polymer-Bindemittelschicht 0,1 bis 10 Vol.-% elektrisch leitfähige Teilchen mit einer mittleren Teilchengröße von 1 bis 50 $\mu$m dispergiert sind, wobei das Verhältnis des minimalen Teilchendurchmessers zu dem maximalen Teilchendurchmesser jedes Teilchens 0,5 bis 1,0 beträgt,
   (iii) der Film vor der Anwendung von Hitze und Druck nicht elektrisch leitfähig ist,
   (iv) nach der plastischen Deformation durch Anwendung von Hitze und Druck der Film in Richtung der Dicke, jedoch nicht in irgendeiner Richtung der Ebene, elektrisch leitfähig ist und daß die elektrisch leitfähigen Teilchen einen spezifischen Widerstand von $10^{-5}$ $\Omega$-cm oder weniger haben und daß der Film eine Gesamt-Lichtdurchlässigkeit von 40% oder mehr, gemessen nach der JIS-Norm K-6714, hat.

2. Film nach Anspruch 1, dadurch **gekennzeichnet,** daß der Klebstoff ein hitzeempfindlicher Klebstoff ist, der als Hauptkomponente ein thermoplastisches Polymeres enthält.

3. Film nach Anspruch 2, dadurch **gekennzeichnet,** daß das thermoplastische Polymere ein Ethylen-Vinylacetat-Copolymeres, ein Polyethylen, ein Ethylen-Propylen-Copolymeres, ein Ethylen-Acrylat-Copolymeres, ein Acrylkautschuk, ein Polyisobutylen, ein ataktisches Polypropylen, ein Poly(vinylbutyral), ein Styrol-Butadien-Copolymeres, ein Polybutadien, Ethylcellulose, ein Polyamid, ein Polyurethan oder ein Gemisch davon ist.

4. Film nach Anspruch 1, dadurch **gekennzeichnet,** daß der Klebstoff ein druckempfindlicher Klebstoff ist, der ein Polymeres enthält, das bei Raumtemperatur klebrig ist.

5. Film nach Anspruch 4, dadurch **gekennzeichnet,** daß das Polymere ein Acrylkautschuk, Naturkautschuk, ein Siliconkautschuk, ein Polychloropren, ein Butadien-Styrol-Copolymeres, ein Ethylen-Vinylacetat-Copolymeres, ein Polyisobutylen, ein Poly(vinylether)kautschuk oder ein Gemisch davon ist.

6. Film nach einem der vorstehenden Ansprüche, dadurch **gekennzeichnet,** daß er in Richtung der Ebene einen Widerstand von $10^6$ $\Omega$-cm oder mehr, eine minimale Isolierungsbreite von 0,05 mm, einen Widerstand in Richtung der Dicke von $10^3$ $\Omega$-cm oder weniger und eine Klebfestigkeit von 300 g/cm oder mehr hat.

7. Film nach einem der vorstehenden Ansprüche, dadurch **gekennzeichnet,** daß die elektrisch leitfähigen Teilchen Teilchen von Ni, Fe, Cr, Co, Al, Sb, Mo, Cu, Ag, Pt, Au oder einem Gemisch davon oder Glas-oder Kunststoffteilchen, die mit diesen Metallen beschichtet sind, sind.

8. Verfahren zum Verbinden von Schaltungen, dadurch **gekennzeichnet,** daß man einen Film, der nicht elektrisch leitfähig ist und eine Schicht eines Polymer-Bindemittels mit einer Dicke von nicht mehr als 100 $\mu$m, in dem 0,1 bis 10 Vol.-% elektrisch leitfähige Teilchen mit einer mittleren Teilchengröße von 1 bis 50 $\mu$m dispergiert sind, umfaßt, wobei das Verhältnis des minimalen Teilchendurchmessers zu dem maximalen Teilchendurchmesser jedes Teilchens 0,5 bis 1,0 beträgt, die Dicke der Bindemittelschicht mindestens 110% der mittleren Teilchengröße der elektrisch leitfähigen Teilchen beträgt und das Polymer-Bindemittel ein Klebstoff ist, wobei der elektrische Verbindungsfilm eine Gesamt-Lichtdurchlässigkeit von mindestens 40%, gemessen nach der JIS-Norm K-6714, aufweist, zwischen zwei Schaltungsplatten einlegt, die jeweils auf den jeweiligen einander gegenüberliegenden Oberflächen mit Verbindungsanschlüssen versehen sind, wobei mindestens eine der Schaltungsplatten gegenüber Licht durchsichtig ist, daß man die zwei Schaltungen auf die richtigen relativen Positionen optisch einstellt

EP 0 140 619 B1

und die gegenüberliegenden Verbindungsanschlüsse durch Anwendung von Hitze und Druck, um eine derartige plastische Deformation des Films, daß der Film in Richtung der Dicke, jedoch nicht in Richtung irgendeiner Ebene, elektrisch leitfähig wird, zu bewirken, miteinander verbindet.

## Revendications

1. Film électroconducteur anisotrope pour former des connexions électriques par application d'une pression, qui comporte une couche de liant adhésif en polymère dans laquelle sont dispersées des particules électroconductrices, l'épaisseur de la couche de liant étant supérieure à la taille des particules électroconductrices, **caractérisé** en ce que :
   - l'épaisseur de la couche de liant vaut au moins 110 % de la taille moyenne des particules électroconductrices, et n'est pas supérieure à 100 $\mu$m,
   - la couche de liant en polymère contient, de façon dispersée, entre 0,1 et 10 % en volume de particules électroconductrices dont la taille moyenne de particule se situe entre 1 et 50 $\mu$m, le rapport du diamètre minimal de particule au diamètre maximal de particule, pour chaque particule, étant compris entre 0,5 et 1,0,
   - le film n'est pas électroconducteur avant application d'une chaleur et d'une pression,
   - après déformation plastique par application d'une chaleur et d'une pression, le film est électroconducteur dans la direction de l'épaisseur mais ne l'est dans aucune direction plane, les particules électroconductrices ont une résistance spécifique de $10^{-5}$ $\Omega$.cm, ou moins, et le film présente une transmittance totale de la lumière de 40 %, ou plus, quand on la mesure suivant la norme JIS K-6714.

2. Film selon la revendication 1, dans lequel l'adhésif est un adhésif thermosensible contenant un polymère thermoplastique comme composant principal.

3. Film selon la revendication 2, dans lequel le polymère thermoplastique est un copolymère éthylène/acétate de vinyle, un polyéthylène, un copolymère éthylène/propylène, un copolymère éthylène/acrylate, un caoutchouc acrylique, un polyisobutylène, un polypropylène atactique, un polybutyral de vinyle, un copolymère styrène/butadiène, un polybutadiène, une cellulose éthylique, un polyamide, un polyuréthane ou un mélange de ceux-ci.

4. Film selon la revendication 1, dans lequel l'adhésif est un adhésif sensible à la pression qui contient un polymère collant à température ambiante.

5. Film selon la revendication 4, dans lequel le polymère est un caoutchouc acrylique, un caoutchouc naturel, un caoutchouc silicone, un polychloroprène, un copolymère butadiène-styrène, un copolymère éthylèneacétate de vinyle, un polyisobutylène, un caoutchouc polyéther de vinyle, ou un mélange de ceux-ci.

6. Film selon l'une quelconque des précédentes revendications, ayant une résistivité dans la direction plane de $10^6$ $\Omega$.cm ou plus, une largeur minimale d'isolation de 0,05 mm, une résistivité dans la direction de l'épaisseur de $10^3$ $\Omega$.cm ou moins, et une force d'adhésion de 300 g/cm ou plus.

7. Film selon l'une quelconque des précédentes revendications, dans lequel les particules électroconductrices sont des particules de Ni, Fe, Cr, Co, Al, Sb, Mo, Cu, Ag, Pt, Au ou un mélange de ceux-ci, ou bien des particules de verre ou de plastique recouvertes de ces métaux.

8. Procédé pour connecter des circuits qui comporte le fait d'intercaler un film non électro-conducteur, fait d'une couche de liant en polymère dont l'épaisseur n'est pas supérieure à 100 $\mu$m, et dans laquelle sont dispersés 0,1 à 10 % en volume de particules électroconductrices dont la taille moyenne est comprise entre 1 et 50 $\mu$m, le rapport du diamètre minimal de particule au diamètre maximal de particule étant, pour chaque particule, compris entre 0,5 et 1,0, l'épaisseur de la couche de liant valant au moins 110 % de la taille moyenne des particules électroconductrices, et le liant polymère étant un adhésif, le film de connexion électrique présentant une transmittance totale de la lumière d'au moins 40 % quand on la mesure suivant la norme JIS K-6714, entre deux plaquettes de circuit qui comportent chacune des bornes de connexion sur leurs surfaces respectives en vis-à-vis l'une de l'autre, l'une au moins des plaquettes de circuit étant transparente à la lumière, le fait de régler optiquement les deux

14

circuits pour les positionner correctement l'un par rapport à l'autre, et de relier ensemble les bornes de connexion opposées par application d'une chaleur et d'une pression qui provoquent la déformation plastique du film de telle sorte que le film devient électroconducteur dans la direction de l'épaisseur, mais ne l'est dans aucune direction plane.

# F I G . 1

# F I G . 2

# F I G . 3

16